(19) **Europäisches Patentamt**

**European Patent Office**

**Office européen des brevets**

(11) Veröffentlichungsnummer: **0 279 268**
**B1**

(12) # EUROPÄISCHE PATENTSCHRIFT

(45) Veröffentlichungstag der Patentschrift:
03.10.90

(51) Int. Cl.⁵: **H03K 17/97, H03K 17/95**

(21) Anmeldenummer: **88101418.7**

(22) Anmeldetag: **02.02.88**

(54) Störfeldfester Näherungsschalter.

(30) Priorität: **17.02.87 DE 3704893**

(43) Veröffentlichungstag der Anmeldung:
**24.08.88 Patentblatt 88/34**

(45) Bekanntmachung des Hinweises auf die Patenterteilung:
**03.10.90 Patentblatt 90/40**

(84) Benannte Vertragsstaaten:
**AT BE DE ES FR GB IT NL SE**

(56) Entgegenhaltungen:
**EP-A- 0 169 582**
**EP-A- 0 171 013**
**EP-A- 0 179 384**
**DE-A- 2 815 711**
**DE-A- 3 313 326**
**DE-A- 3 606 586**
**FR-A- 2 477 807**

(73) Patentinhaber: **Werner Turck GmbH & Co. KG,
Goethestrasse 7, D-5884 Halver(DE)**

(72) Erfinder: **Müller, Jens, Industriestrasse 10,
D-5608 Radevormwald(DE)**

(74) Vertreter: **Peerbooms, Rudolf, Dipl.-Phys.,
Postfach 200 208 Dickmannstrasse 45c,
D-5600 Wuppertal 2(DE)**

## Beschreibung

Die Erfindung betrifft einen störfeldfesten Näherungsschalter mit einem durch einen Dauermagneten beeinflußbaren Schwingkreis, der durch einen aus amorphem Metall bestehenden Spulenkern im Grundzustand bedämpft ist und durch eine Annäherung des Dauermagneten entdämpfbar ist, und mit einer ersten, an den Oszillatorausgang angeschlossenen Signalausweteschaltung in Form einer Kippstufe, welche ein dem Entdämpfungszustand des Oszillators entsprechendes Ausgangssignal liefert.

Derartige störfeldfeste Näherungsschalter werden in solchen Fällen benötigt, bei denen im Bereich des Näherungsschalters Störfelder auftreten, die dazu führen können, daß Fehlschaltungen ausgelöst werden. Dies ist beispielsweise beim Einsatz von Näherungsschaltern zur Meldung der Stellung von Kolben in Pneumatikzylindern der Fall, die bei Schweißanlagen, speziell bei Schweißrobotern, Verwendung finden. Durch die in der Nähe der Pneumatikzylinder vorbeigeführten Stromzuführungskabel für die elektrischen Schweißaggregate können so hohe magnetische Felder erzeugt werden, daß sie bei ungeschützten Näherungsschaltern Fehlschaltungen auslösen.

Durch die EP-OS 01 79 384 ist ein störfeldfester Näherungsschalter bekannt, bei dem jeder Näherungsschalter jeweils zwei auf die Annäherung ansprechende sensorische Teile enthält und bei dem die Differenz der Signale der beiden sensorischen Teile ausgewertet wird. Aufgrund der räumlichen Anordnung der beiden sensorischen Teile ist die Differenz der Signale bei Entstehung durch Störfelder wesentlich geringer als bei Entstehung durch die Annäherungen. Dadurch sind die Störfeldeinflüsse wesentlich herabgesetzt. Diese bekannte Anordnung ist aber nur bei Näherungsschaltern möglich, deren Sensoren nicht oder nur schwer magnetisch sättigbar sind. Bei Verwendung sättigbarer Sensoren würden dort die Sensoren im Sättigungsfall die Signale gleichen Pegel erreichen, so daß eine Differenzauswertung nicht mehr möglich wäre.

Durch die DE-OS 28 15 711 ist ferner ein Näherungsschalter bekannt, der einen auf eine metallische Steuerfahne ansprechende Oszillatoranordnung aufweist. Damit dort das Ausgangssignal des Näherungsschalters nicht unbeabsichtigt durch elektromagnetische Wechselfelder verfälscht wird, werden die Zustandsänderungen des Oszillators absichtlich zeitlich verzögert in die entsprechenden Ausgangssignaländerungen des Näherungsschalters umgesetzt. Bei dieser bekannten Anordnung wird eine Unterdrückung von fehlerhaften Ausgangssignalzuständen, die durch elektromagnetische Wechselfelder verursacht sein könnten, nur erreicht, wenn vorausgesetzt werden kann, daß die Zeitdauer der Einwirkung der störenden elektromagnetischen Wechselfelder begrenzt und bekannt ist. Dies ist bei bestimmten Anwendungen der Fall, z.B. wenn gewährleistet ist, daß die störenden magnetischen Wechselfelder in der Nähe ihrer jeweiligen Nulldurchgänge ausreichend lang niedrig genug sind. Die Aussteuergrenze des amorphen Metallkernes beträgt 1/100 bis 1/1000 der eines Ferritkernes. Bei sinusförmiger Aussteuerung mit magnetischen Feldern wird der Metallkern in 1/100 bis 1/1000 der Zeit gesättigt, in der ein Ferritkern gesättigt wird. Im Fall eines Näherungsschalters mit Auslösung durch einen Dauermagneten sind die Zeiten, die zum taktweisen Zurücksetzen der Einschaltverzögerungszeiten zur Verfügung stehen, so kurz, daß die dort vorgesehene taktweise Austastung im Nulldurchgang des störenden magnetischen Wechselfeldes bei Näherungsschaltern mit Auslösung durch Dauermagneten nicht möglich ist.

Der Erfindung liegt die Aufgabe zugrunde, einen störfeldfesten Näherungsschalter mit Auslösung durch einen Dauermagneten zu schaffen, der trotz Verwendung des leicht magnetisch sättigbaren amorphen Metalles im Oszillator-Spulenkern zuverlässig gegen eine Verfälschung des Ausgangssignales des Näherungsschalters durch störende magnetische Wechselfelder gesichert ist.

Die Lösung dieser Aufgabe wird durch einen Näherungsschalter mit den im Patentanspruch 1 angegebenen Merkmalen erreicht. Von entscheidender Bedeutung ist bei der Erfindung, daß eine Beeinflussung durch störende magnetische Wechselfelder als solche, d. h. als Störung, erfaßt wird und als ein während der Dauer der Beeinflussung fortdauerndes Sperrsignal auf eine sperrbare Halteschaltung gelegt wird. Dadurch wird das Ausgangssignal des Näherungsschalters auf demjenigen Zustand festgehalten, der vor dem Auftreten einer störenden Beeinflussung vorgelegen hat. Es bleibt damit gewährleistet, daß die beispielsweise von den mit erfindungsgemäßen Näherungsschaltern überwachten Pneumatikzylindern betätigten Greifeinrichtungen während des Schweißvorganges in ihrer Stellung sicher gehalten bleiben und also erst nach Beendigung des Schweißvorganges und damit nach Wegfall der von den Schweißströmen herrührenden störenden magnetischen Wechselfelder wieder geöffnet und verstellt werden können.

Der Näherungsschalter nach der Erfindung wird im folgenden anhand der Figuren näher beschrieben. Dabei zeigen:

Fig. 1 ein allgemeines Blockschaltbild des erfindungsgemäßen Näherungsschalters und

Fig. 2 ein detailliertes Schaltbild zum Blockschaltbild nach Fig. 1.

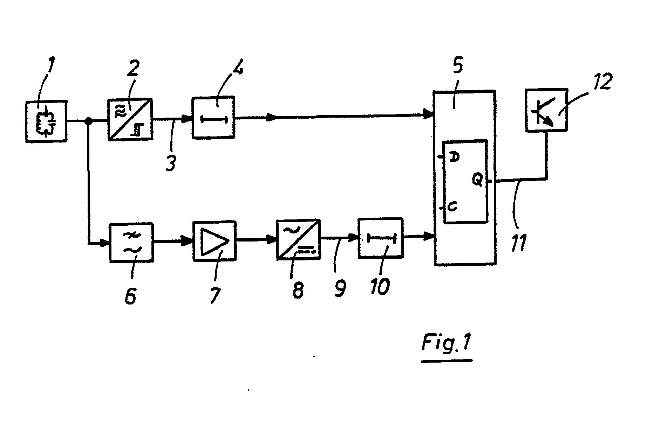

Das Blockschaltbild nach Fig. 1 zeigt einen Schwingkreis 1 als sensorischen Teil des Näherungsschalters, welcher bei Annäherung eines Dauermagneten entdämpft wird und seinen Ausgang an eine Signalausweteschaltung 2 liefert, die an ihrem Ausgang 3 ein binäres Signal über eine Verzögerungsstufe 4 an den D-Eingang einer sperrbaren Halteschaltung 5 liefert.

Der Schwingkreis 1 ist ebenfalls durch ein Stör-Wechselfeld entdämpfbar, und in einem solchen Falle wird ebenfalls über die Signalausweteschaltung 2 und die Verzögerungsstufe 4 ein Signal an den D-Eingang der Halteschaltung 5 geliefert.

Der Ausgang des Schwingkreises 1 wird ferner an ein Filter 6 geführt, welches nur ein störfrequentes Ausgangssignal erfaßt und über einen Verstärker 7 und eine Auswerteschaltung 8 in ein binäres Signal am Ausgang 9 umwandelt, welches über eine Verzögerungsschaltung 10 an den C-Eingang der sperrbaren Halteschaltung 5 geliefert wird. Wenn am C-Eingang ein Störsignal ansteht, ist die Halteschaltung für den Nutzsignalweg 2, 3, 4 gesperrt, und am Ausgang 11 der Halteschaltung 5 bleibt das Signal auf dem zuletzt eingenommenen Wert. Liegt kein Signal am C-Eingang vor, was gleichbedeutend damit ist, daß kein Störfeld vorliegt, wird der Ausgang des Schwingkreises 1 über den Nutzsignalweg 2, 3, 4 und die Halteschaltung 5 normal durchgeschaltet und damit die Endstufe 12 geschaltet.

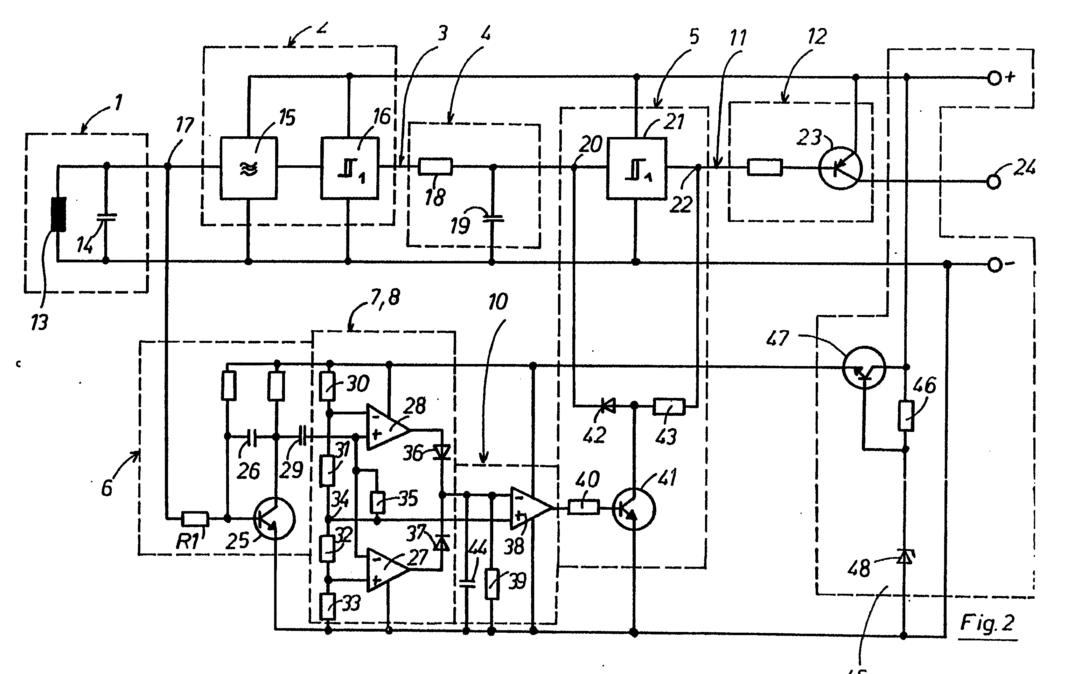

Die vorgenannte Schaltungsanordnung wird im folgenden anhand des detaillierten Schaltbildes nach Fig. 2 näher erläutert. Der Schwingkreis 1 besteht aus einer Schwingkreisspule 13, deren Spulenkern leicht magnetisch sättigbares amorphes Metall enthält, und aus einem Kondensator 14. Dabei ist dieser Schwingkreis 1 im Grundzustand durch das amorphe Material bedämpft. Bei Annäherung eines Dauermagneten wird das amorphe Material gesättigt und dadurch wird der Schwingkreis 1 entdämpft. Die Oszillator- und Auswerteschaltung 2 besteht aus einem Oszillator 15 und einer invertierenden Kippstufe 16. Diese Oszillator- und Auswerteschaltung 2 betreibt den Schwingkreis 1 und gibt an ihrem Ausgang 3 ein binäres Signal ab entsprechend dem bedämpften bzw. dem entdämpften Zustand des Schwingkreises 1. Bei dieser bis hierher bekannten Anordnung kann aus dem am Ausgang 3 der Oszillator- und Auswerteschaltung 2 im entdämpften Zustand anstehenden Signal nicht erkannt werden, ob die Entdämpfung in beabsichtigter Weise durch die Annäherung eines Dauermagneten oder in unbeabsichtigter Weise durch die Beeinflussung eines störenden elektromagnetischen Wechselfeldes entstanden ist.

Damit eine von einem Störfeld bewirkte Entdämpfung des Schwingkreises 1 nicht zu einer Umschaltung der Endstufe 12 führt, ist erfindungsgemäß der Ausgang des Schwingkreises 1 zusätzlich über ein Filter 6 und einen Verstärker 7 einer Störauswerteschaltung 8 zugeführt. Dabei sind das Filter 6 und die Störauswerteschaltung 8 so abgestimmt, daß die Störauswerteschaltung 8 nicht auf das Annähern bzw. das Entfernen des Dauermagneten anspricht. Vielmehr ist die Störauswerteschaltung 8 besonders empfindlich gemacht auf die von magnetischen Wechselfeldern generierten Signale, d. h. im Falle von netzfrequenten Störfeldern auf die Netzfrequenz. Die Störauswerteschaltung liefert so an ihrem Ausgang 9 ein binäres Signal, dessen Zustand vom Vorhandensein oder Nichtvorhandensein einer störenden Beeinflussung des Schwingkreises 1 abhängt.

Die beiden binären Signale an den Ausgängen 3 und 9 werden der sperrbaren Halteschaltung 5 zugeführt, deren Signal an ihrem Ausgang 11 bereits dem Ausgangssignal des erfindungsgemäßen Näherungsschalters entspricht. Dabei ist diese Halteschaltung 5 so eingerichtet, daß die vom Ausgang 3 der Oszillator- und Auswerteschaltung 2 kommenden Signalzustände dann und nur dann auf den Ausgang 11 der Halteschaltung 5 durchgeschaltet werden, wenn das vom Ausgang 9 der Störauswerteschaltung 8 kommende Signal ausweist, daß kein magnetisches Wechselfeld den Schwingkreis 1 beeinflußt. In diesem Falle entspricht also das Signal am Ausgang 11 der Halteschaltung 5 dem Annäherungszustand am Schwingkreis 1. Zeigt dagegen das Signal am Ausgang 9 der Störauswerteschaltung 8 an, daß der Schwingkreis 1 von einem magnetischen Wechselfeld beeinflußt wird, so wird das vom Ausgang 3 der Oszillator- und Auswerteschaltung 2 kommende Signal gesperrt und der am Ausgang 11 der Halteschaltung 5 vorhandene Signalzustand unverändert gehalten, unabhängig davon, welchen Zustand das Signal am Ausgang 3 der Oszillator- und Auswerteschaltung 2 annimmt.

Auf diese Weise ist gewährleistet, daß der Ausgang 11 und damit auch der Ausgang des Gesamt-Näherungsschalters in beabsichtigter Weise nur vom Annäherungszustand des Dauermagneten gesteuert wird und daß der Ausgang nicht durch Einwirkung von magnetischen Wechselfeldern auf den Schwingkreis 1 verfälscht werden kann.

Anhand der Schaltung nach Fig. 2 wird die Funktion des Näherungsschalters im durch magnetische Wechselfelder nicht-beeinflußten Zustand beschrieben, wobei der obere Teil von Fig. 2 den Schaltungsteil zeigt, welcher das Schaltsignal verarbeitet.

Der Oszillator 15 betreibt den Schwingkreis 1. Das am Schaltungspunkt 17 anstehende vom Bedämpfungszustand abhängige analoge Signal wird der invertierenden Kippstufe 16 zugeführt, an deren Ausgang 3 dann ein binäres Signal ansteht, wie anhand der Fig. 1 beschrieben wurde. Der Widerstand 18 und der Kondensator 19 bilden das Verzögerungsglied 4 nach Fig. 1, über welches das binäre Signal vom Ausgang 3 zum Eingang 20 einer weiteren Kippstufe 21 gelangt. Diese Kippstufe 21 ist ein Teil der sperrbaren Halteschaltung 5 nach Fig. 1. Im unbeeinflußten Zustand entspricht das Signal am Ausgang 22 der Kippstufe 21, das identisch mit dem Ausgang 11 der Halteschaltung 5 ist, dem Signal am Eingang 20 und entspricht also dem Bedämpfungszustand und damit auch dem Annährungszustand eines Dauermagneten. Vom Schaltungspunkt 22 wirkt das binäre Signal auf die Basis des Schalttransistors 23, der die Endstufe 12 nach Fig. 1 bildet. Der Kollektor des je nach Annäherungszustand gesperrten oder durchgeschalteten Transistors 23 führt zum Signalausgang 24 des Näherungsschalters.

Im unteren Teil der Schaltung nach Fig. 2 ist die Anordnung zur Erfassung und Auswertung von Störbeeinflussungen durch magnetische Wechselfelder gezeigt.

Das am Schwingkreis 1 anstehende analoge Signal wird vom Punkt 17 über einen Widerstand R1 der Basis eines Transistors 25 zugeführt. Dabei verstärkt der Transistor 25 die hochfrequenten Oszillatorsignale nicht, weil er für diese hochfrequenten Signale durch den Kondensator 26 extrem gegengekoppelt ist.

Solange kein störendes magnetisches Wechselfeld vorliegt, also in die Schwingkreisspule 13 keine störfrequenten Spannungen induziert und über 17, den Widerstand R1 an den Transistor 25 weitergeleitet werden, bleiben die Komparatoren 27 und 28, deren Eingänge an einem Kondensator 29 und einem Spannungsteiler 30, 31, 32, 33 angeschlossen sind, in Ruhestellung, wie im folgenden gezeigt wird: Da über jeder Hälfte des Spannungsteilers 30, 31, 32, 33 die Hälfte der Versorgungsspannung abfällt, liegt das Mittenpotential vom Punkt 34 über den Widerstand 35 am positiven Eingang des Komparators 28 und am negativen Eingang des Komparators 27. Der negative Eingang des Komparators 28 liegt um den Spannungsabfall am Widerstand 31 über seinem positiven Eingang, so daß der Ausgang des Komparators 28 das Minus-Potential der Schaltung annimmt. Weiter liegt der positive Eingang des Komparators 27 um den Spannungsabfall am Widerstand 32 unter seinem negativen Eingang, so daß auch der Ausgang des Komparators 27 das Minus-Potential der Schaltung annimmt. Dadurch fließt weder durch die Diode 36 noch durch die Diode 37 ein Strom, und der negative Eingang eines weiteren Komparators 38 liegt über den Widerstand 39 am Minus-Potential der Schaltung. Da der positive Eingang des Komparators 38 am Mittenpotential Punkt 34 liegt, liegt er höher als das Potential am negativen Eingang, so daß der Ausgang des Komparators 38 am Plus-Potential der Schaltung liegt. Der dann über den Widerstand 40 in die Basis des Transistors 41 fließende Strom macht diesen leitend.

Der durchgeschaltete Transistor 41 verbindet den Eingang 20 der Kippstufe 21 über die Diode 42 in Sperrichtung mit dem Minus-Potential der Schaltung. Ebenso wird der Ausgang 22 der Kippstufe 21 über den Widerstand 43 mit dem Minus-Potential verbunden. Beides hat keinen Einfluß auf die Signale an der Kippstufe 21 und somit auch keinen Einfluß auf die oben beschriebene Funktion der im oberen Teil der Fig. 2 gezeigten Schaltung. Dieser Teil wirkt also im durch störende magnetische Felder nichtbeeinflußten Zustand wie oben beschrieben.

Wenn ein störendes magnetisches Wechselfeld vorliegt, induziert dieses in der Spule 13 des Schwingkreises 1 eine störfrequente Wechselspannung, die der hochfrequenten Schwingspannung des Oszillators überlagert ist. Diese überlagerten Spannungen werden vom Punkt 17 über den Widerstand R1 an die Basis des Transistors 25 gelegt. Das hochfrequente Oszillatorsignal wird dabei, wie oben beschrieben, wegen der hochfrequenten Gegenkopplung über den Kondensator 26 nicht verstärkt. Der störfrequente, also niederfrequente Anteil wird dagegen etwa 100-fach verstärkt am Kollektor des Transistors 25 wirksam. Über den Kondensator 29 gelangt das verstärkte störfrequente Signal an die Eingänge der Komparatoren 27 und 28. Überschreitet die Amplitude der positiven Halbwelle der störfrequenten Spannung am positiven Eingang des Komparators 28 die Spannung an seinem negativen Eingang, so schaltet sein Ausgang für die Zeit der Überschreitung auf das Plus-Potential der Schaltung. Unterschreitet die Amplitude der negativen Halbwelle der störfrequenten Spannung am negativen Eingang des Komparators 27 die Spannung an seinem positiven Eingang, so schaltet sein Ausgang für die Zeit der Unterschreitung ebenfalls auf das Plus-Potential der Schaltung. So gelangen positive Impulse abwechselnd über die Diode 36 und über die Diode 37 an den Kondensator 44 und an den negativen Eingang des Komparators 38. Bei schwachen Störfeldern entstehen zwischen den einzelnen positiven Impulsen jeweils Pausen, z.B. von 8 Millisekunden, bei einer Störfrequenz von 50 Hz. Diese Pausen werden durch das den Kondensator 44 und den Widerstand 39 enthaltende Verzögerungsglied 10 überbrückt, indem der Kondensator 44 wechselweise über die Dioden 36 und 37 geladen wird und die Spannung am negativen Eingang des Komparators 38 für die Zeit der Pause auf positivem Potential hält. Bei stärkeren Störfeldern sind die entstehenden Pausen kürzer; sie werden in angegebener Weise ebenfalls überbrückt.

Überschreitet nun die Ladespannung am Kondensator 44 und damit die Spannung am negativen Eingang des Komparators 38 die Mittenspannung von Punkt 34 am positiven Eingang des Komparators 38, so schaltet dessen Ausgang auf das Minus-Potential der Schaltung. Damit sperrt der Transistor 41, und vom Ausgang 22 der Kippstufe 21 kann ein Haltestrom über den Widerstand 43 und die Diode 42 zum Eingang 20 der Kippstufe 21 fließen. Dadurch wird diese Kippstufe 21 im gegebenen Schaltzustand gehalten, was bewirkt, daß auch der Ausgang 24 des Näherungsschalters im vorherigen Zustand bleibt. Diese Wirkung hält so lange an, wie ein entsprechend hohes störendes magnetisches Wechselfeld auf den Schwingkreis 1 einwirkt.

Die Verzögerung durch das Verzögerungsglied 4 im Nutzsignalzweig wird dabei größer gemacht als die Verzögerung durch die Laufzeit im Störsignalzweig. Damit wird erreicht, daß beim Auftreten von störenden magnetischen Wechselfeldern die Sperr- oder Haltewirkung an der sperrbaren Halteschaltung 5 am Punkt 20 früher als die Nutzsignalverfälschung von der Oszillator- und Auswerteschaltung 2 eintrifft.

Fig. 2 zeigt ferner noch die Speise- und Stabilisierungsschaltung 45 zur Versorgung des Näherungsschalters. Die Schaltung 45 enthält einen zwischen der positiven und negativen Versorgungsleitung geschalteten Widerstand 46, dem die Kollektor-Basis-Strecke eines Transistors 47 parallel geschaltet ist. Eine Zener-Diode 48 liegt mit ihrer Kathode an der Basis des Transistors 47 und mit ihrer Anode am Minuspotential.

Der erfindungsgemäße Näherungsschalter kann also sein Ausgangssignal nicht ändern, solange störende magnetische Wechselfelder auf den Näherungsschalter einwirken.

**Patentansprüche**

1. Störfeldfester Näherungsschalter,
- mit einem durch einen Dauermagneten beeinflußbaren Schwingkreis (1), der durch einen aus amorphem Metall bestehenden Kern einer Spule (13) im Grundzustand bedämpft ist und durch eine Annäherung des Dauermagneten entdämpfbar ist,
- mit einer ersten, an den Schwingkreisausgang (17) angeschlossenen Signalauswerteschaltung (2), welche ein dem Entdämpfungszustand des Schwingkreises (1) entsprechendes Ausgangssignal liefert,
- mit einer sperrbaren Halteschaltung (5) in Form eines D-Flip-Flops mit einem Schaltsignaleingang (D) und mit einem Sperrsignaleingang (C), an dessen Schaltsignaleingang (D) der Ausgang (3) der ersten Signalauswerteschaltung (2) angeschlossen ist,
- mit einer zweiten an den Schwingkreisausgang (17) über ein Filter (6) angeschlossenen Signalauswerteschaltung (8), wobei das Filter (6) auf die Frequenz des zu berücksichtigenden Stör-Wechselmagnetfeldes abgestimmt ist und nur bei Auftreten eines störfeldfrequenten Schwingkreis-Ausgangssignales über eine Kippstufe der Signalauswerteschaltung (8) ein für die Dauer der Störung ununterbrochenes Sperrsignal an den Sperrsignaleingang (C) der sperrbaren Halteschaltung (5) liefert, bei der das Signal am Ausgang (11) bei Auftreten eines Sperrsignales auf dem zuletzt eingenommenen Wert festgehalten wird, so daß der Ausgang der Halteschaltung (5) durch Annäherung oder Entfernung des Dauermagneten nicht mehr beeinflußbar ist,
- mit einer der Halteschaltung (5) nachgeschalteten Endstufe (12), die aus einem elektronischen Schalter für den zu schaltenden Stromkreis und aus einer Zündeinrichtung für den elektronischen Schalter besteht,
- und mit einer Speiseschaltung für den Schwingkreis (1) und die beiden Signalauswerteschaltungen (2 und 8).

2. Näherungsschalter nach Anspruch 1, dadurch gekennzeichnet, daß das Ausgangssignal der Signalauswerteschaltung (2) über ein Verzögerungsglied (4) verzögert an die Halteschaltung (5) geliefert wird.

3. Näherungsschalter nach den Ansprüchen 1 und 2, dadurch gekennzeichnet, daß eine Signaländerung am Ausgang (9) der Störauswerteschaltung (8), die durch den Fortfall einer Einwirkung fremder magnetischer Störfelder auftritt, über ein Verzögerungsglied (10) zeitlich verzögert gegenüber einer Signaländerung, die am Ausgang (3) der Signalauswerteschaltung (2) durch den Fortfall einer Einwirkung durch fremde magnetische Felder auftritt, der Halteschaltung (5) zugeführt wird.

## Claims

1. Proximity switch immune to interference fields
- with an oscillator circuit (1) controllable by a permanent magnet, this oscillator circuit being damped in its basic condition by a core of a coil (13), which core consists of amorphous metal, and being undampable by an approach of the permanent magnet,
- with a first signal evaluating circuit (2) connected to the oscillator circuit output (17) and yielding an output signal corresponding to the undamped condition of the oscillator circuit (1),
- with a blockable holding circuit (5) in the form of a D flip-flop with a switching signal input (D) and with a blocking signal input (C), the output (3) of the first signal evaluating circuit (2) being connected to the switching signal input (D) of this flip-flop,
- with a second signal evaluating circuit (8) connected via a filter (6) to the oscillator circuit output (17), wherein the filter (6) is tuned to the frequency of the interfering alternating magnetic field to be considered and transmits a blocking signal, continuous over the duration of the interference, to the blocking signal input (C) of the blockable holding circuit (5) only upon the occurrence of an oscillator circuit output signal of interference field frequency, by way of a multivibrator stage of the signal evaluating circuit (8), the signal being retained at the output (11) of the holding circuit, upon the occurrence of a blocking signal, at the lastassumed value so that the output of the holding circuit (5) can no longer be influenced by an approach or distancing of the permanent magnet,
- with a final stage (12) connected after the holding circuit (5) and consisting of an electronic switch for the circuit to be switched and of a firing device for the electronic switch,
- and with a supply circuit for the oscillator circuit (1) and the two signal evaluating circuits (2 and 8).

2. Proximity switch according to claim 1, characterized in that the output signal of the signal evaluating circuit (2) is transmitted by way of a delay member (4) with a delay to the holding circuit (5).

3. Proximity switch according to claims 1 and 2, characterized in that a signal change at the output (9) of the interference evaluating circuit (8), occurring on account of the absence of an effect of foreign magnetic interference fields, is transmitted to the holding circuit (5) by way of a delay member (10) with time delay as compared with a signal change occurring at the output (3) of the signal evaluating circuit (2) on account of the absence of an effect by foreign magnetic fields.

## Revendications

1. Interrupteur de proximité insensible aux champs perturbateurs qui comporte:
- un circuit oscillant (1), influençable par un aimant permanent, qui est amorti en l'état initial au moyen du noyau en métal amorphe d'une bobine (13) et dont l'amortissement peut être supprimé par l'approche de l'aimant permanent,
- un premier circuit d'exploitation de signaux (2), raccordé au circuit oscillant (17), qui émet un signal de sortie correspondant à l'état de désamortissement du circuit oscillant (1),
- un circuit de maintien (5) blocable, sous forme d'une bascule D, à une entrée de signal de contact (D) et une entrée de signal de blocage (C), à l'entrée de signal de contact (D) duquel est raccordée la sortie (3) du premier circuit d'exploitation de signaux (2),
- un deuxième circuit d'exploitation de signaux (8), raccordé par l'intermédiaire d'un filtre (6) à la sortie (17) du circuit oscillant, le filtre (6) étant conçu pour la fréquence du champ magnétique alternatif perturbateur à considérer et ne fournissant, par l'intermédiaire d'un étage de bascule du circuit d'exploitation de signaux (8), un signal de blocage, ininterrompu pendant la durée de la perturbation, à l'entrée de signal de blocage (C) du circuit de maintien (5) blocable, que lors de l'apparition d'un signal de sortie de circuit oscillant à la fréquence du champ perturbateur, entrée à laquelle le signal émis à la sortie (11), lors de la présence d'un signal de blocage, est maintenu à la dernière valeur prise par le signal, de sorte que la sortie du circuit de maintien (5) n'est plus influençable par l'approche ou l'éloignement de l'aimant permanent, – un étage de sortie (12), mis en circuit en aval de l'étage de maintien (5), qui se compose d'un contacteur électronique pour le circuit électrique à mettre en contact et d'un moyen d'allumage pour le contacteur électronique, – et un circuit d'alimentation pour le circuit oscillant (1) et les deux circuits d'exploitation de signaux (2 et 8).

2. Interrupteur de proximité selon la revendication 1, caractérisé en ce que le signal de sortie du circuit d'exploitation de signaux (2) est fourni avec retard au circuit de maintien (5), par l'intermédiaire d'un organe de retardement (4).

3. Interrupteur de proximité selon les revendications 1 et 2, caractérisé en ce qu'une variation du signal à la sortie (9) du circuit d'exploitation des signaux (8), qui survient du fait de la disparition d'une action de champs magnétiques perturbateurs extérieurs, est fournie au circuit de maintien (5), avec retard, produit par l'intermédiaire d'un organe retardateur (10), par rapport à une variation du signal qui survient à la sortie (3) du circuit d'exploitation des signaux du fait de la disparition de l'effet de champs magnétiques extérieurs.

EP 0 279 268 B1

*Fig.1*

Fig.2